# EUROPEAN PATENT APPLICATION

(11) **EP 4 550 402 A1**
(43) Date of publication of application: **07.05.2025**
(21) Application number: 24208734.4
(22) Date of filing: 24.10.2024
(51) Int. Cl.: H01L 23/15, H01L 23/498

(54) **PACKAGING SUBSTRATE AND SEMICONDUCTOR PACKAGE COMPRISING THE SAME**

(30) Priority: 02.11.2023 US 202363595725 P
(71) Applicant: Absolics Inc., Covington, GA 30014 (US)
(72) Inventor: WOO, Yong Ha, Covington, Georgia 30014 (US)
(74) Representative: BCKIP Part mbB

(57) **Abstract**

A packaging substrate and a semiconductor package are provided. The packaging substrate according to a present disclosure includes a glass core. The glass core includes a through via passing through the glass core in a thickness direction of the glass core. The glass core has a surface. The packaging substrate includes a crack prevention layer surrounding at least a portion of the surface. In the packaging substrate, a ratio of a thickness of the crack prevention layer to a thickness of the glass core is 0.0001 to 0.05.

In this case, a packaging substrate having excellent durability against a thermal impact and a mechanical impact may be provided.

## Description

This application claims the priority benefit of United States provisional application No. 63/595,725 filed on November 2, 2023.

### BACKGROUND

### Technical Field

Present disclosure relates to a packaging substrate and a semiconductor package including the same.

### Description of Related Art

In manufacturing electronic components, implementing a circuit on a semiconductor wafer is called a front-end (FE) process, assembling the wafer in a state of being usable in an actual product is called as a back-end (BE) process, and a packaging process is included in the back-end processes.

The four core technologies of the semiconductor industry, which recently enabled rapid development of electronic products, include semiconductor technology, semiconductor packaging technology, manufacturing process technology, and software technology. Semiconductor technology has developed in various forms, such as nanoscale (submicron) line widths, 10 million cells or more, high-speed operation, large heat dissipation, and the like, but the packaging technology does not support the semiconductor technology relatively perfectly. Accordingly, the electrical performance of a semiconductor can sometimes be determined by the packaging technology and an electrical connection according to the packaging technology rather than the performance of the semiconductor technology itself.

A ceramic or resin is applied as a material of a packaging substrate. In the case of ceramic substrates, it is difficult to mount a high-performance and high-frequency semiconductor element due to their high resistance value or high dielectric permittivity. In the case of resin substrates, a relatively high-performance and high-frequency semiconductor element can be mounted, but there is a limit to reducing the pitch of lines.

Recently, research on applying silicon or glass to a high-end packaging substrate is in progress. A line length between an element and a motherboard can be shortened and excellent electrical characteristics can be achieved by forming a through hole in a silicon substrate or glass substrate and applying a conductive material to the through hole.

### SUMMARY

A packaging substrate according to one embodiment of the present specification includes a glass core.

The glass core includes a through via passing through the glass core in a thickness direction of the glass core.

The glass core has a surface.

The packaging substrate includes a crack prevention layer surrounding at least a portion of the surface of the glass core.

In the packaging substrate, a ratio of a thickness of the crack prevention layer to a thickness of the glass core is 0.0001 to 0.05.

A tensile strength of the crack prevention layer may be 1 Mpa to 20 Mpa.

A linear thermal expansion coefficient of the crack prevention layer may be 100 ppm/°C to 800 ppm/°C.

A dielectric constant of the crack prevention layer at a frequency of 100 Hz may be 4 or less.

The packaging substrate may include a first electrically conductive layer disposed on the crack prevention layer.

A peel strength of the first electrically conductive layer with respect to a surface of the crack prevention layer may be 300 gf or more.

The packaging substrate may further include an adhesion reinforcement layer disposed between the elastic layer and the first electrically conductive layer.

The crack prevention layer may be roughened.

At least a portion of the crack prevention layer may be disposed in contact with the surface of the glass core.

A peel strength of the crack prevention layer with respect to the surface of the glass core may be 400 gf or more.

The crack prevention layer may include a silicone elastomer.

The surface of the glass core may include an upper surface and side surfaces connected to the upper surface and formed in the thickness direction of the glass core.

The crack prevention layer may surround the side surfaces of the glass core.

The through via may include an inner space and a via inner diameter surface surrounding the inner space.

The crack prevention layer may be disposed between the inner space and the via inner diameter surface.

A minimum value of a diameter of the inner space may be 50 µm or more.

A semiconductor package according to another embodiment of the present specification includes the packaging substrate and a semiconductor element mounted on the packaging substrate.

### BRIEF DESCRIPTION OF THE DRAWINGS

FIG. 1A is a cross-sectional view for describing a packaging substrate according to one embodiment of the present disclosure.
FIG. 1B is a plan view for describing the packaging substrate according to one embodiment of the present disclosure.
FIG. 2 is an enlarged view of portion A in FIG. 1A.
FIG. 3 is a cross-sectional view for describing a packaging substrate according to another embodiment of the present disclosure.
FIG. 4 is a cross-sectional view for describing a packaging substrate according to still another embodiment of the present disclosure.

### DESCRIPTION OF THE EMBODIMENTS

Hereinafter, embodiments will be described in detail with reference to the accompanying drawings which may allow those skilled in the art to easily practice the present disclosure. However, the present disclosure may be implemented in various forms and is not limited to embodiments described herein. The same reference numerals are used for similar components throughout the specification.

Throughout the present specification, the term "combination thereof" included in expression of the Markush form refers to a mixture or combination of one or more selected from the group consisting of components disclosed in the expression of the Markush form, and refers to including the one or more selected from the group consisting of the components.

Throughout the present specification, terms such as "first," "second," "A" or "B" are used to distinguish the same terms. Further, a singular form includes a plural form unless otherwise clearly defined in the context.

In the present specification, "~" based may refer to including a compound corresponding to "-" or a derivative of the "~" in the compound.

In the present specification, "B is disposed on A" means that B is disposed directly on A or B is disposed on A while another layer is located therebetween, and is not understood as being limited to a case in which B is disposed in contact with the surface of A.

In the present specification, "B is connected on A" means that B is directly connected to A or B is connected to A through another component therebetween, and is not understood as being limited to a case in which B is directly connected to A unless otherwise specifically mentioned.

In the present specification, a singular form is interpreted as including a singular form or plural form unless otherwise specifically described.

In the present specification, shapes, relative sizes, angles, and the like of components in the drawings are illustrative and may be exaggerated for the purpose of description, and the scope is not understood as being limited to the drawings.

In the present specification, a case in which "B is adjacent to A" means that A and B are located in contact with each other or A and B are located close to each other although not in contact with each other. The expression that "A and B are adjacent to each other" is not understood as being limited to a case in which A and B are located in contact with each other unless otherwise specifically mentioned.

In the present specification, unless otherwise described, a fine line refers to a line having a width of 5 µm or less, and for example, refers to a line having a width of 1 to 4 µm or less.

Unless otherwise specifically described in the present specification, the physical property values of each component in a packaging substrate are interpreted as being measured at room temperature. Room temperature is 20°C to 25°C.

A through via may be formed in a glass core for high integration of the packaging substrate and optimization of a signal transmission path. However, due to high hardness of a glass material, the glass core having this complicated structure may be easily damaged due to various impacts in a manufacturing process.

Specifically, in a process of forming a redistribution layer on the glass core, the glass core may be repeatedly exposed to high temperature and low temperature environments. This may cause the internal stress of the glass core to increase. Further, in a substrate having the glass core as a component, cracks may easily occur even by a small mechanical impact during movement and the work process.

The inventors of the present disclosure experimentally found that the packaging substrate can have stable durability against a thermal impact and a mechanical impact and cracks can be suppressed from spreading widely throughout the glass core by applying a crack prevention layer on the packaging substrate, and completed the present disclosure.

Hereinafter, the present disclosure will be described in detail.

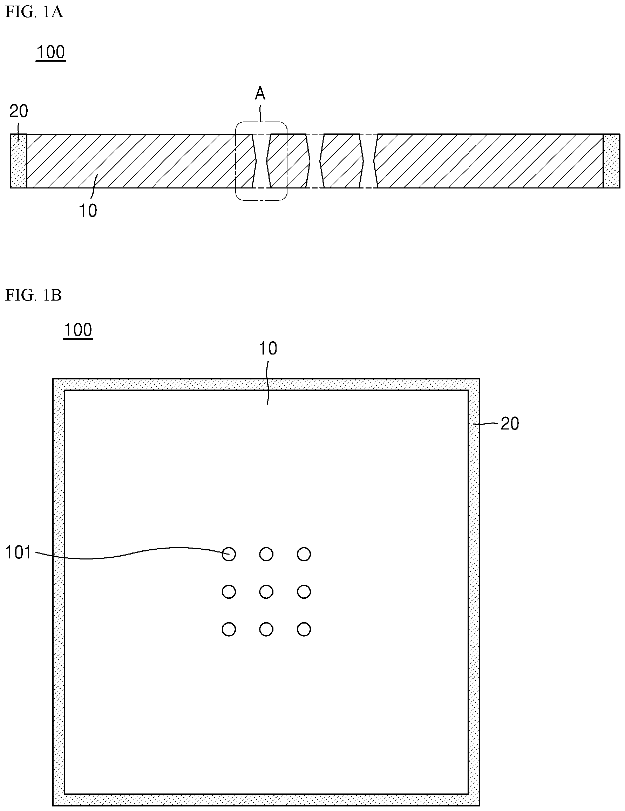

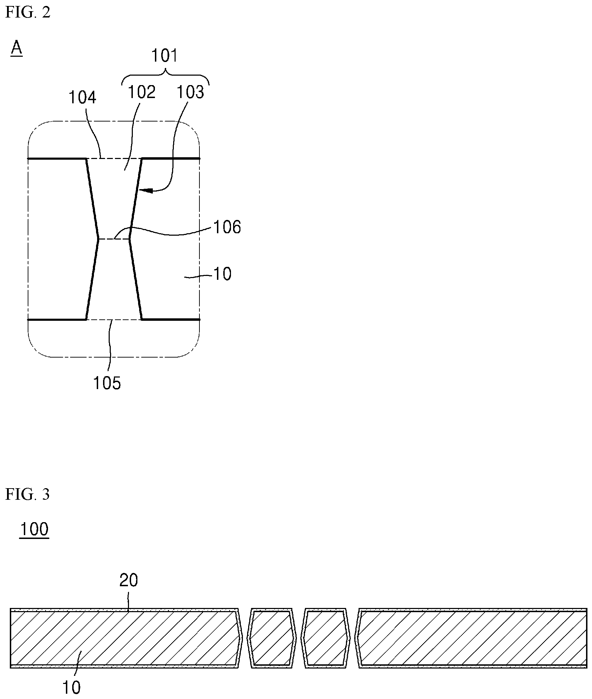

FIG. 1A is a cross-sectional view for describing a packaging substrate according to one embodiment of the present disclosure. FIG. 1B is a plan view for describing the packaging substrate according to one embodiment of the present disclosure. FIG. 2 is an enlarged view of portion A in FIG. 1A. The present disclosure will be described with reference to FIGS. 1A, 1B and 2.

### Glass core

A packaging substrate 100 according to the present disclosure may include a glass core 10.

The glass core 10 may have the shape of a glass substrate. For example, alkaline borosilicate plate glass, alkali-free borosilicate plate glass, alkali-free alkaline earth borosilicate plate glass, or the like may be applied as the glass core 10, and any plate glass that is applied as electronic components may be applied as the glass core 10. A glass substrate for an electronic device may be applied as the glass core 10, and for example, products manufactured by manufacturers such as Schott, Corning, AGC, or the like may be applied, but are not limited thereto.

A thickness of the glass core 10 may be 50 µm or more. The thickness may be 100 µm or more. The thickness may be 250 µm or more. The thickness may be 400 µm or more. The thickness may be 500 µm or more. The thickness may be 3000 µm or less. The thickness may be 2000 µm or less. The thickness may be 1000 µm or less. When a glass core 10 having such a thickness is applied, a semiconductor element may be stably fixed and protected.

The glass core 10 may include a through via 101 passing through the glass core 10 in a thickness direction of the glass core 10.

The through via 101 is composed of an inner space 102 and a via inner diameter surface 103 surrounding the inner space 102. The inner space 102 refers to an empty space, and the via inner diameter surface 103 refers to a surface of the glass core 10 formed in the through via 101.

The through via 101 may have a diameter which changes in the thickness direction of the glass core 10. The through via 101 may have a substantially uniform diameter in the thickness direction of the glass core 10.

A cross-section of the through via 101 may have an hourglass shape. The cross-section of the through via 101 may have a rectangular shape, a triangular shape, a trapezoidal shape, or the like in addition to the sandglass shape. The cross-section of the through via 101 refers to a cross-section of the through via 101 in the thickness direction of the glass core 10.

The through via 101 may include a first opening 104 which is in contact with an upper surface of the glass core 10 and a second opening 105 which is in contact with a lower surface of the glass core 10.

The through via 101 may further include a minimum inner diameter portion 106 which connects the first opening 104 and the second opening 105, and is a portion having the smallest inner diameter. A diameter of the through via 101 at the minimum inner diameter portion 106 may be smaller than a diameter of the through via 101 at the first opening 104. The diameter of the through via 101 at the minimum inner diameter portion 106 may be smaller than a diameter of the through via 101 at the second opening 105.

When the through via 101 includes the minimum inner diameter portion 106, the cross-section of the through via 101 may have an hourglass shape. In the case of the through via 101 having an hourglass-shaped cross section, it may be easier to form a thin film on the via inner diameter surface 103 through coating, sputtering, or the like. Accordingly, when an electrically conductive layer and/or a crack prevention layer 20 is formed in the through via 101, the reliability of the packaging substrate 100 may be further improved.

A diameter of the through via 101 at the first opening 104 may be 40 µm to 200 µm. The diameter may be 60 µm or more. The diameter may be 80 µm or more. The diameter may be 100 µm or more. The diameter may be 180 µm or less. The diameter may be 160 µm or less. The diameter may be 140 µm or less. The diameter may be 120 µm or less.

A diameter of the through via 101 at the second opening 105 may be 40 µm to 200 µm. The diameter may be 60 µm or more. The diameter may be 80 µm or more. The diameter may be 100 µm or more. The diameter may be 180 µm or less. The diameter may be 160 µm or less. The diameter may be 140 µm or less. The diameter may be 120 µm or less.

In this case, the electrical reliability of the packaging substrate 100 may be stably controlled while further improving the degree of integration of the packaging substrate 100.

The diameter of the through via 101 at the minimum inner diameter portion 106 may have a size of 50% to 99% of a smaller value between a diameter of the through via 101 at the first inner diameter portion and a diameter of the through via 101 at the second inner diameter portion. The diameter of the through via 101 at the minimum inner diameter portion 106 may be 60% or more of the smaller value between the diameter of the through via 101 at the first inner diameter portion and the diameter of the through via 101 at the second inner diameter portion. The diameter of the through via 101 at the minimum inner diameter portion 106 may be 70% or more of the smaller value between the diameter of the through via 101 at the first inner diameter portion and the diameter of the through via 101 at the second inner diameter portion. The diameter of the through via 101 at the minimum inner diameter portion 106 may be 90% or less of the smaller value between the diameter of the through via 101 at the first inner diameter portion and the diameter of the through via 101 at the second inner diameter portion. The diameter of the through via 101 at the minimum inner diameter portion 106 may be 80% or less of the smaller value between the diameter of the through via 101 at the first inner diameter portion and the diameter of the through via 101 at the second inner diameter portion. In this case, it may help to form the crack prevention layer 20 and/or the electrically conductive layer with a uniform thickness throughout the via inner diameter surface 103.

The surfaces of the glass core 10 may include an upper surface and side surfaces connected to the upper surface and formed in the thickness direction of the glass core 10. The surface of the glass core 10 may include a lower surface facing the upper surface.

A case in which the side surfaces are formed in the thickness direction of the glass core 10 is interpreted as a meaning including not only a case in which the side surface forms a right angle with the upper surface of the glass core 10, but also a case in which at least a portion of the side surface forms an angle other than 90 degrees (an inclination angle) with the upper surface.

The side surface may be a plane, and may also be a curved surface.

The glass core 10 may include a cavity, which is a space formed as the inside is recessed.

The cavity may be formed as a portion of the upper or lower surface of the glass core 10 is recessed in the thickness direction of the glass core 10, or may pass through the glass core 10 in the thickness direction of the glass core 10.

An element may be mounted in the cavity and thus may be electrically connected to the packaging substrate 100. Not only a semiconductor element such as a central processing unit (CPU), a graphics processing unit (GPU), a memory chip, or the like but also a capacitor element, a transistor element, an impedance element, other modules, or the like may be applied as the element. That is, any semiconductor element mounted on a semiconductor device may be applied as the element without limitation.

### Structure of crack prevention layer

The glass core 10 may have a surface. The packaging substrate 100 may include the crack prevention layer 20 surrounding at least a portion of the surface of the glass core 10.

The crack prevention layer 20 may stably support the glass core 10 in a high temperature environment to prevent the glass core 10 from bending and damage due to the internal stress of the glass core 10 and effectively suppress cracks, which have already occurred in the glass core, 10 from propagating over a wider area. Further, the crack prevention layer 20 provides adjusted elasticity to a preset region of the packaging substrate 100 to stably protect the packaging substrate 100 from a mechanical impact which occurs in a process in which an operator handles the packaging substrate 100.

In the present disclosure, a ratio of a thickness of the glass core 10 and a thickness of the crack prevention layer 20 may be adjusted within a preset range. In this case, the durability of the packaging substrate 100 against an external impact may be improved by more solidly supporting and protecting the glass core 10. At the same time, a thermal treatment time required in a process of forming the crack prevention layer 20 through thermal treatment may be adjusted to suppress excessive thermal deformation of the glass core 10.

The thickness of the crack prevention layer 20 means a thickness value of the crack prevention layer 20 disposed on the upper surface, side surface, or lower surface of the glass core 10. That is, the thickness value of the crack prevention layer 20 means the thickness of the crack prevention layer 20 that is not formed in the through via 101. When the thickness of the crack prevention layer 20 is not uniform for each location, an average thickness of the crack prevention layer 20 is set as the thickness of the crack prevention layer 20 according to the present disclosure.

The ratio of the thickness of the crack prevention layer 20 to the thickness of the glass core 10 may be 0.0001 to 0.05. The ratio may be 0.0005 or more. The ratio may be 0.001 or more. The ratio may be 0.003 or more. The ratio may be 0.005 or more. The ratio may be 0.03 or less. The ratio may be 0.02 or less. In this case, the packaging substrate 100 having improved durability may be provided without excessive damage to the glass core 10.

The thickness of the crack prevention layer 20 may be 100 nm to 50 µm. The thickness may be 500 nm or more. The thickness may be 1 µm or more. The thickness may be 3 µm or more. The thickness may be 5 µm or more. The thickness may be 40 µm or less. The thickness may be 30 µm or less. The thickness may be 20 µm or less. In this case, the crack prevention layer 20 may solidly support the glass core 10 and effectively prevent the formation and propagation of cracks in the glass core 10. Further, the crack prevention layer 20 may be formed within an adjusted curing time.

The crack prevention layer 20 may surround the side surfaces of the glass core 10.

An external force applied to the packaging substrate 100 during handling by an operator may mainly impact in a side surface direction of the glass core 10. The crack prevention layer 20 formed with the above-described structure may more effectively protect the glass core 10 from a mechanical impact.

The crack prevention layer 20 surrounding the side surfaces of the glass core 10 may surround not only the side surfaces of the glass core 10 but also at least a portion of the upper surface and/or the lower surface of the glass core 10. In this case, the crack prevention layer 20 may cover edges of the upper surface and/or the lower surface.

A case in which the crack prevention layer 20 surrounds the glass core 10 is interpreted as a meaning including not only a case in which the crack prevention layer 20 surrounds the glass core 10 while in contact with the glass core 10 but also a case in which the crack prevention layer 20 surrounds the side surfaces of the glass core 10 with other components disposed between the crack prevention layer 20 and the glass core 10.

FIG. 3 is a cross-sectional view for describing a packaging substrate according to another embodiment. Hereinafter, the present disclosure will be described with reference to FIG. 3.

The packaging substrate includes a glass core. The specific configurations of the packaging substrate are the same as those described above in FIGs. 1A, 1B and 2. Hereinafter, the description will focus on the differences.

The crack prevention layer 20 may be disposed between the inner space 102 and the via inner diameter surface 103. Since the through via 101 has a fine and complicated structure, a surrounding region of the through via 101 may correspond to a portion in the glass core 10 that is particularly vulnerable to an impact. When the crack prevention layer 20 has such a structure, the formation and propagation of cracks in the glass core 10 may be more effectively prevented.

When the crack prevention layer 20 has the above-described structure, in the present disclosure, a minimum value of a diameter of the inner space 102 may be adjusted within a predetermined range. In this case, since an electrically conductive layer may be relatively easily formed without voids in the through via 101, the electrical reliability of the packaging substrate 100 may be improved to a certain level or higher.

The minimum value of the diameter of the inner space 102 may be 50 µm or more. The minimum value may be 65 µm or more. The minimum value may be 80 µm or more. The minimum value may be 200 µm or less. The minimum value may be 180 µm or less. The minimum value may be 120 µm or less. In this case, the electrically conductive layer may be easily formed in the through via 101.

The crack prevention layer 20 may have a structure surrounding the entire surface of the glass core 10. That is, the crack prevention layer 20 may be disposed not only on the sides of the through via 101 but also on the upper surface, the lower surface, and the side surfaces of the glass core 10. Accordingly, it is possible to help protect the glass core 10 from an external impact and prevent cracks from spreading throughout the glass core 10.

### Properties of crack prevention layer

In the present disclosure, a tensile strength of the crack prevention layer 20 may be controlled. This crack prevention layer 20 has the adjusted strength and may stably fix the glass core 10, which can be deformed by thermal stress. Accordingly, it is possible to suppress the occurrence of defects due to bending of the glass core 10 during a manufacturing process, especially a redistribution layer formation process. Further, the crack prevention layer 20 may provide appropriate elasticity to at least a portion of the packaging substrate 100 and alleviate an impact applied to the glass core 10 from the outside.

The tensile strength of the crack prevention layer 20 may be measured through a universal testing machine (UTM).

The tensile strength of the crack prevention layer 20 may be 1 Mpa to 20 Mpa. The tensile strength may be 2 MPa or more. The tensile strength may be 4 MPa or more. The tensile strength may be 15 MPa or less. The tensile strength may be 10 MPa or less. In this case, even when the glass core 10 has a structure vulnerable to an impact, the packaging substrate 100 may have stable durability.

The crack prevention layer 20 may have a linear thermal expansion coefficient within a predetermined range in the present disclosure. The crack prevention layer 20 having this characteristic may prevent the glass core 10 from being damaged as an external force due to thermal expansion of the crack prevention layer 20 itself applied to the glass core 10 is adjusted during the redistribution layer formation process. Further, when the electrically conductive layer is disposed in contact with the crack prevention layer 20, damage to an electrical connection due to expansion of the crack prevention layer 20 may be suppressed.

The linear thermal expansion coefficient is a value measured using dynamic mechanical analysis (DMA).

The linear thermal expansion coefficient of the crack prevention layer 20 is 100 ppm/°C to 800 ppm/°C. The linear thermal expansion coefficient may be 150 ppm/°C or more. The linear thermal expansion coefficient may be 200 ppm/°C or more. The linear thermal expansion coefficient may be 250 ppm/°C or more. The linear thermal expansion coefficient may be 300 ppm/°C or more. The linear thermal expansion coefficient may be 700 ppm/°C or less. The linear thermal expansion coefficient may be 600 ppm/°C or less. The linear thermal expansion coefficient may be 500 ppm/°C or less. The linear thermal expansion coefficient may be 400 ppm/°C or less. In this case, the packaging substrate 100 may have stable durability and electrical reliability even after repeated thermal treatment.

In the present disclosure, the dielectric properties of the crack prevention layer 20 may be controlled. When the electrically conductive layer is formed on the crack prevention layer 20, the crack prevention layer 20 may function as an insulator. When a high-density fine pattern is implemented on the crack prevention layer 20 having adjusted dielectric properties, signal confusion between lines may be suppressed and the power consumption of the packaging substrate 100 due to the dielectric properties of the crack prevention layer 20 may be reduced.

A dielectric constant of the crack prevention layer 20 is measured using a dielectric constant meter at room temperature.

The dielectric constant of the crack prevention layer 20 at a frequency of 100 Hz may be 4 or less. The dielectric constant may be 3.5 or less. The dielectric constant may be 3 or less. The dielectric constant may be 2.8 or less. The dielectric constant may be 1.5 or more.

The dielectric constant of the crack prevention layer 20 at a frequency of 100 KHz may be 4 or less. The dielectric constant may be 3.5 or less. The dielectric constant may be 3 or less. The dielectric constant may be 2.8 or less. The dielectric constant may be 1.5 or more.

In this case, an electrically conductive layer pattern formed on the crack prevention layer 20 may efficiently transmit signals.

The packaging substrate 100 may include a first electrically conductive layer (not shown) disposed on the crack prevention layer 20. A peel strength of the first electrically conductive layer with respect to the crack prevention layer 20 may be 300 gf or more.

The electrically conductive layer is a conducting wire which transmits electrical signals. The electrically conductive layers may include the first electrically conductive layer. The first electrically conductive layer is an electrically conductive layer disposed most adjacent to the crack prevention layer 20 among the electrically conductive layers. At least a portion of the first electrically conductive layer may be formed in contact with the crack prevention layer 20. The electrically conductive layer may include an electrically conductive material. For example, the electrically conductive layer may include at least one of copper, nickel, aluminum, gold, or silver. Copper or the like may be applied as a material of the electrically conductive layer.

When the first electrically conductive layer is formed on the crack prevention layer 20, the crack prevention layer 20 may serve as a support and an insulator for the first electrically conductive layer. In the present disclosure, the adhesion between the crack prevention layer 20 and the first electrically conductive layer may be improved so that the crack prevention layer 20 may stably fix the first electrically conductive layer.

The peel strength of the first electrically conductive layer with respect to the crack prevention layer 20 is measured using a bond tester according to a 180° peel test. A measurement speed (a peel speed) is set to 10 mm/s, a measurement distance (a peel distance) is set to 70 mm, and a measurement region is set as a region where the through via is not formed among the upper surface and the lower surface of the glass core. For example, a peel strength value may be measured using an XYZ TEC's Condor Sigma bond tester.

An average value of the measured peel strength values is set as the peel strength of the first electrically conductive layer with respect to the crack prevention layer 20.

The peel strength of the first electrically conductive layer with respect to the crack prevention layer 20 may be 300 gf or more. The peel strength may be 350 gf or more. The peel strength may be 400 gf or more. The peel strength may be 450 gf or more. The peel strength may be 500 gf or more. The peel strength may be 1200 gf or less. In this case, the crack prevention layer 20 may help form an elaborate fine pattern on the upper surface of the glass core 10 by stably supporting and fixing the first electrically conductive layer.

In the present disclosure, in order to further improve the adhesion between the crack prevention layer 20 and the first electrically conductive layer, an adhesion reinforcement layer (not shown) may be disposed between the crack prevention layer 20 and the first electrically conductive layer (or the electrically conductive layer).

The adhesion reinforcement layer may further improve the adhesion between the crack prevention layer 20 made of an organic material and the first electrically conductive layer (or the electrically conductive layer) to more stably maintain the electrical reliability of the first electrically conductive layer (or the electrically conductive layer).

The adhesion reinforcement layer may be any one selected from the group consisting of an azole-based compound, a silane-based compound, a silanized azole-based compound, and a combination thereof. The adhesion reinforcement layer having this composition may effectively improve the adhesion of the electrically conductive layer without excessively etching the electrically conductive layer.

In order to further improve the peel strength of the first electrically conductive layer with respect to the crack prevention layer 20, the crack prevention layer 20 may be roughened. A contact area between the crack prevention layer 20 and the first electrically conductive layer may be increased by making the roughness of the surface of the crack prevention layer 20 higher, and the peel strength may be further increased by causing an anchor effect at an interface between the crack prevention layer 20 and the first electrically conductive layer.

At least a portion of the crack prevention layer 20 may be disposed in contact with the surface of the glass core 10. The peel strength of the crack prevention layer 20 with respect to the surface of the glass core 10 may be 400 gf or more.

The adhesion between the crack prevention layer 20 and the glass core 10 at a portion where the crack prevention layer 20 and the glass core 10 are in contact may be controlled within the scope of the present disclosure. Accordingly, the crack prevention layer 20 may not be easily separated from the glass core 10, and the crack prevention layer 20 may stably support and protect the glass core 10. Further, an electrical connection between the electrically conductive layer pattern formed on the crack prevention layer 20 and the electrically conductive layer pattern formed in another region of the packaging substrate 100 may be prevented from being easily disconnected.

The peel strength of the crack prevention layer 20 with respect to the surface of the glass core 10 is measured under the same conditions as a method of measuring the peel strength of the first electrically conductive layer with respect to the crack prevention layer 20.

The peel strength of the crack prevention layer 20 with respect to the surface of the glass core 10 may be 400 gf or more. The peel strength may be 450 gf or more. The peel strength may be 500 gf or more. The peel strength may be 550 gf or more. The peel strength may be 600gf or more. The peel strength may be 1200 gf or less. In this case, the crack prevention layer 20 is not easily separated from the surface of the glass core 10 to help stably maintain the durability and electrical reliability of the packaging substrate 100.

### Composition of crack prevention layer

The crack prevention layer 20 may include a silicone elastomer.

The silicone elastomer may impart the desired mechanical physical properties of present disclosure to the crack prevention layer 20 to stably fix the glass core 10 in a high temperature atmosphere and working environment. Further, the silicone elastomer may be cured through thermal treatment within a relatively short time after light treatment. Accordingly, stiffness may be reinforced by improving the crosslinking density of the crack prevention layer 20, and deformation of the glass core 10 due to thermal stress may be suppressed as the time during which the glass core 10 is exposed to a high temperature in the process of forming the crack prevention layer 20 is adjusted.

The crack prevention layer 20 may include 70% by weight or more of the silicone elastomer. The crack prevention layer 20 may include 80% by weight or more of the silicone elastomer. The crack prevention layer 20 may include 90% by weight or more of the silicone elastomer. The crack prevention layer 20 may include 100% by weight or less of the silicone elastomer. The crack prevention layer 20 may be the silicone elastomer. In this case, since improved stiffness is imparted to the crack prevention layer 20, the glass core 10 may be stably fixed, and a bending degree of the glass core 10 in a substrate manufacturing process may be lowered to a certain level or less.

The silicone elastomer may be cross-linked with a base material, which is a silicon resin and a curing agent.

The base material may include an alkene group at one or more ends. The base material may have a structure of the following Chemical Formula 1.

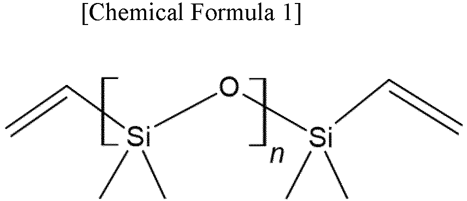

In Chemical Formula 1, n is an integer from 20 to 60.

The curing agent may have a structure of the following Chemical Formula 2.

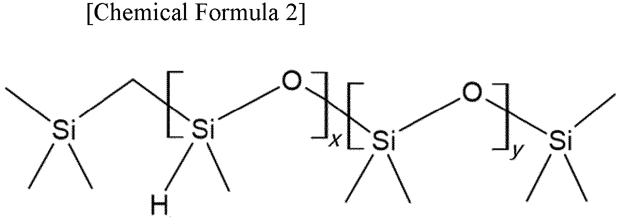

In Chemical Formula 2, x and y are each independently integers from 2 to 10.

In a curing process, the alkene group included in the base material may form a cross-link with the curing agent. Accordingly, the crosslinking density in the blended resin may be improved, and adjusted stiffness may be imparted to the crack prevention layer 20.

When the crack prevention layer 20 is formed, 3 to 20 parts by weight of the curing agent may be applied based on 100 parts by weight of the base material. When the crack prevention layer 20 is formed, 5 parts by weight or more of the curing agent may be applied based on 100 parts by weight of the base material. When the crack prevention layer 20 is formed, 8 parts by weight or more of the curing agent may be applied based on 100 parts by weight of the base material. When the crack prevention layer 20 is formed, 15 parts by weight or less of the curing agent may be applied based on 100 parts by weight of the base material. In this case, it may help to impart the desired stiffness and elasticity in the present disclosure to the crack prevention layer 20.

The crack prevention layer 20 may further include a metal catalyst. The metal catalyst may help the crosslinking of the silicone elastomer to proceed in a short period of time. For example, a platinum catalyst may be used as the metal catalyst.

The crack prevention layer 20 may further include other additives other than the blended resin. The additive is not limited as long as it is commonly used in the film field.

### Other components of packaging substrate

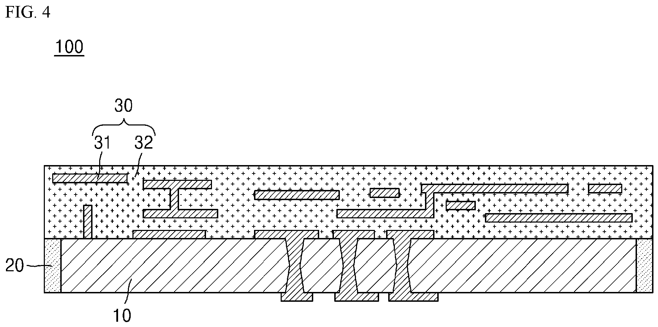

FIG. 4 is a schematic diagram for describing a packaging substrate according to still another embodiment of the present disclosure. Hereinafter, the embodiment will be described with reference to FIG. 4.

The packaging substrate includes a glass core. The specific configurations of the packaging substrate are the same as those described above in FIGS. 1A, 1B, 2, and 3. Hereinafter, the description will focus on the differences.

A redistribution layer 30 may include an insulating layer 32 and an electrically conductive layer 31 disposed in the insulating layer 32.

The packaging substrate 100 may include a redistribution layer 30 disposed on the glass core 10. The packaging substrate 100 may include a redistribution layer 30 disposed under the glass core 10. The packaging substrate 100 may include redistribution layers 30 disposed on and under the glass core 10.

The redistribution layer 30 may be disposed in a through via 101. The electrically conductive layer 31 may be disposed in the through via 101. When only the electrically conductive layer 31 is present in the through via 101, the electrically conductive layer 31 may be formed by filling the inner space 102 of the through via 101. When both the electrically conductive layer 31 and the insulating layer 32 are present in the through via 101, the electrically conductive layer 31 may be disposed adjacent to the via inner diameter surface 103, and the insulating layer 32 may be disposed in a region surrounded by the electrically conductive layer 31.

The redistribution layer 30 may be disposed in contact with the surface of the glass core 10. Other components may be disposed between the redistribution layer 30 and the surface of the glass core 10. A crack prevention layer 20 may be disposed between the redistribution layer
30 and the surface of the glass core 10.

In the redistribution layer 30, the insulating layer 32 and the electrically conductive layer 31 may be disposed in a mixed manner. The redistribution layer 30 may be formed in a form in which the electrically conductive layer 31 having a predetermined location and form is embedded in the insulating layer 32. The electrically conductive layer 31 may be formed as a fine line in at least a portion of the redistribution layer 30. The redistribution layer 30 may be electrically connected to an upper terminal and/or a lower terminal, an element, or the like of the packaging substrate 100.

The redistribution layer 30 may be formed through a process of repeatedly forming and removing the insulating layer 32 and the electrically conductive layer 31.

The insulating layer 32 may be formed using, for example, a build-up layer material such as an Ajinomoto build-up film (ABF) of Ajinomoto, an undercoat material, or the like, but is not limited thereto.

The description of a material of the electrically conductive layer 31 overlaps the above-described content and thus will be omitted.

The packaging substrate 100 may further include the redistribution layer 30 disposed under the glass core 10 and/or a bump (not shown).

The bump may be disposed in a predetermined form under the glass core 10. For example, the bump may be disposed on a portion of the lower surface of the packaging substrate 100 so as to come into contact with a main board or the like.

### Semiconductor package

A semiconductor package according to still another embodiment of the present disclosure includes a packaging substrate and an element electrically connected to the packaging substrate.

The packaging substrate may be mounted on a main board and electrically connected to the main board.

Descriptions of the packaging substrate and the element overlap the above-described content and thus will be omitted.

### Method of manufacturing packaging substrate

A method of manufacturing a packaging substrate according to yet another embodiment of the present specification includes a through via formation operation of forming a through via passing through a glass substrate in a thickness direction of the glass substrate to prepare the glass core, and a crack prevention layer manufacturing operation of forming a crack prevention layer surrounding at least a portion of the glass core surface to manufacture a packaging substrate.

In the through via formation operation, for example, alkaline borosilicate plate glass, alkali-free borosilicate plate glass, alkali-free alkaline earth borosilicate plate glass, or the like may be applied as the glass substrate, and any plate glass that is applied as electronic components may be applied as the glass core. A glass substrate for an electronic device may be applied as the glass core, and for example, products manufactured by manufacturers such as Schott, AGC, Corning, or the like may be applied, but are not limited thereto.

In the through via formation operation, the glass core may be prepared by etching a glass substrate. Specifically, defects may be formed at predetermined locations on a surface of the glass substrate. Mechanical etching, laser irradiation, and the like may be applied as a method of forming defects.

After forming the defects, a through via may be formed through physical or chemical etching. When chemical etching is applied, wet etching may be performed using an etching solution. The etching solution is not limited as long as it is commonly applicable to etching a glass substrate. For example, a sulfuric acid solution, a nitric acid solution, a hydrofluoric acid solution, or the like may be applied as the etching solution.

In the etching process, the remaining surface of the glass substrate excluding the regions where the defects are formed may be masked, and etching may be performed without masking.

Defects may be formed at one point on an upper surface of the glass substrate, defects may be formed at another point on a lower surface of the glass substrate facing the one point, and the etching may be performed to form a through via having an hourglass shaped cross-section.

An opening at the upper surface of the formed through via is called a first opening, an opening at the lower surface is called a second opening, and a portion of the through via having the smallest diameter is called a minimum inner diameter portion.

Descriptions of the first opening, the second opening, and the minimum inner diameter portion overlap the above-described content and thus will be omitted.

In the crack prevention layer manufacturing operation, the crack prevention layer may be formed at a predetermined location on the glass core. The description of the location where the crack prevention layer is disposed overlaps the above-described content and thus will be omitted.

The crack prevention layer may be formed using a lamination or wet coating method.

In the lamination process, the packaging substrate may be manufactured by laminating a film-shaped crack prevention layer at a predetermined location on the glass core.

In the wet coating method, the crack prevention layer may be formed by applying a composition for manufacturing a crack prevention layer to a predetermined location on the glass core and curing the composition for manufacturing a crack prevention layer.

The composition for manufacturing a crack prevention layer may include a base material of a silicone elastomer and a curing agent. Descriptions of the compositions of the silicone elastomer base material and the curing agent overlap the above-described content and thus will be omitted.

The composition for manufacturing a crack prevention layer may include 3 to 20 parts by weight of the curing agent based on 100 parts by weight of the base material. The composition for manufacturing a crack prevention layer may include 5 parts by weight or more of the curing agent based on 100 parts by weight of the base material. The composition for manufacturing a crack prevention layer may include 8 parts by weight or more of the curing agent based on 100 parts by weight of the base material. The composition for manufacturing a crack prevention layer may include 15 parts by weight or less of the curing agent based on 100 parts by weight of the base material. In this case, it may help to impart the desired physical properties in the present disclosure to the crack prevention layer.

The composition for manufacturing a crack prevention layer may be coated using a method such as spin coating, slit coating, or the like but is not limited thereto.

The crack prevention layer may be formed by thermally curing the applied composition for manufacturing a crack prevention layer.

The composition for manufacturing a crack prevention layer may be cured at a relatively low thermal treatment temperature. The relatively low thermal treatment temperature may be 70°C to 120°C. The temperature may be 80°C or higher. The temperature may be 90°C or higher. The temperature may be 110°C or lower.

When the composition for manufacturing a crack prevention layer is cured at a relatively low thermal treatment temperature, thermal treatment may proceed for a relatively long time. In this case, the thermal treatment time of the composition for manufacturing a crack prevention layer may be 30 to 90 minutes. The thermal treatment time may be 40 minutes or more. The thermal treatment time may be 50 minutes or more. The thermal treatment time may be 80 minutes or less.

In this case, the formation of excessive thermal stress in the glass core in a process of forming the crack prevention layer may be suppressed.

The composition for manufacturing a crack prevention layer may be cured at a relatively high thermal treatment temperature. The relatively low thermal treatment temperature may be 120°C to 180°C. The temperature may be 130°C or higher. The temperature may be 140°C or higher. The temperature may be 170°C or lower.

When the composition for manufacturing a crack prevention layer is cured at a relatively high thermal treatment temperature, thermal treatment may be performed for a relatively short time. In this case, the thermal treatment time of the composition for manufacturing a crack prevention layer may be 5 to 30 minutes. The thermal treatment time may be 10 minutes or more. The thermal treatment time may be 15 minutes or more. The thermal treatment time may be 25 minutes or less.

In this case, thermal deformation of the glass core may be suppressed by reducing the time the glass core is exposed to high temperature heat.

The description of the thickness of the formed crack prevention layer overlaps the above-described content and thus will be omitted.

The surface of the crack prevention layer may be roughened to improve the adhesion of the electrically conductive layer to the crack prevention layer. In the process of forming the crack prevention layer, as the thermal treatment time and the thermal treatment temperature may be adjusted, the adhesion of the electrically conductive layer to the crack prevention layer may be adjusted.

As another method of improving the adhesion of the electrically conductive layer to the crack prevention layer, an adhesion reinforcement layer may be formed on the surface of the crack prevention layer. The description of the adhesion reinforcement layer overlaps the above-described content and thus will be omitted.

A redistribution layer may be formed on the packaging substrate in which the crack prevention layer is formed. After forming the electrically conductive layer on the glass core or crack prevention layer, the redistribution layer may be formed by forming an insulating layer surrounding the electrically conductive layer.

The electrically conductive layer may be formed using a dry method or wet method.

The dry method is a method of performing sputtering in a region where the electrically conductive layer is to be disposed to form a seed layer and performing plating in a region where the seed layer is formed to form the electrically conductive layer. When the seed layer is formed, metals such as titanium, chromium, nickel, and the like may be sputtered, and the sputtering may be performed by applying the above-described metals and copper together. Since an anchor effect in which metal particles interact with a surface of a glass core, a crack prevention layer, or an insulating layer occurs through sputtering, the adhesion of the electrically conductive layer may be improved.

The wet method is a method of applying a primer to a portion where the electrically conductive layer needs to be formed, and then performing metal plating. The primer may include a compound having a functional group such as an amine or the like. The primer may include a compound having a functional group such as an amine and a silane coupling agent according to the intended degree of adhesion. When the silane coupling agent is applied, a primer layer may be formed by pre-treating a surface to be primed with a silane coupling agent and then applying a compound having an amine group to the pre-treated region.

After forming the seed layer or primer layer, an electrically conductive layer may be formed by plating metal. Copper plating may be applied when the electrically conductive layer is formed, but it is not limited thereto. A portion of the seed layer or primer layer where the electrically conductive layer need not be formed may be inactivated, or a portion where the electrically conductive layer need to be formed may be activated before metal plating, and then plating may be performed. Light irradiation treatment using laser of a specific wavelength, chemical treatment, or the like may be applied as activation or deactivation treatment methods. However, after performing the metal plating without applying activation or deactivation treatment, the electrically conductive layer may be etched and patterned according to a previously designed shape.

After forming the electrically conductive layer, an insulating layer surrounding the electrically conductive layer may be formed. The insulating layer may be manufactured in the form of a film. Specifically, the insulating layer may be formed by performing reduced-pressure lamination on the film-shaped insulating layer. In this case, the insulating layer may be formed to surround the electrically conductive layer without voids, so that the packaging substrate may have excellent electrical reliability.

The description of the location where the redistribution layer is disposed overlaps the above-described content and thus will be omitted.

A process of forming a connection terminal, a bump, a cover layer, and the like on the upper and/or lower surface of the packaging substrate, or mounting an element on the substrate may be further performed as necessary.

Hereinafter, the present disclosure will be described in more detail through specific examples. The following examples are only examples for helping understanding of the present disclosure, and the scope of the present disclosure is not limited thereto.

### Manufacturing Example: Manufacture of packaging substrate

Example 1: After forming defects on a surface of a SG7.8 glass substrate (a thickness of 0.7mm) manufactured by Corning through laser irradiation, a plurality of through vias were formed by performing wet etching to manufacture a glass core. An inner diameter of the core via was adjusted to 100 µm.

DOW's Sylgard 184 composition, which is a composition for manufacturing a crack prevention layer, was applied on an upper surface of the glass core. A base material of Sylgard 184 and a curing agent were mixed in a ratio of 10:1 (based on weight) and applied on a glass plate. The applied composition was thermally treated and cured at 100°C for 60 minutes to form a crack prevention layer having a thickness of 8 µm. A nickel layer was formed by sputtering on the crack prevention layer with a nickel target, and sputtering on the nickel layer with a copper target to form a copper layer and complete a seed layer. Copper plating was performed on the seed layer to form a first electrically conductive layer having a total thickness of 1 µm and manufacture a packaging substrate.

Example 2: A packaging substrate was manufactured under the same conditions as Manufacturing Example 1 except that the thickness of the crack prevention layer was 7 µm.

Example 3: A packaging substrate was manufactured under the same conditions as Manufacturing Example 1 except that the thickness of the crack prevention layer was 10 µm.

Example 4: A packaging substrate was manufactured under the same conditions as Manufacturing Example 1 except that the thickness of the crack prevention layer was 11 µm.

Comparative Example 1: A packaging substrate was manufactured under the same conditions as Manufacturing Example 1 except that a crack prevention layer was formed by applying 3M's Scotchgard Film Protector FX-1000 as a composition for manufacturing a crack prevention layer without thermal treatment.

### Evaluation Example: Measurement of peel strength of electrically conductive layer with respect to crack prevention layer

In the packaging substrate for each Example, the peel strength of the first electrically conductive layer with respect to the crack prevention layer was measured using an XYZ TEC's Condor Sigma bond tester according to a 180° peel test. A measurement speed (a peel speed) was set to 10 mm/s, a measurement distance (a peel distance) was set to 70 mm, and a measurement region was set as a region where the through via was not formed. An average value of the peel strength measured in the peeling process of the crack prevention layer for each Example was set as the peel strength for each Example.

The measured values for each Example were listed in the following Table 1.

### Evaluation Example: Thermal resistance evaluation

The packaging substrate for each Example and Comparative Example was exposed to 100°C for 10 minutes. Thereafter, the packaging substrate for each Example and Comparative Example was observed with the naked eye, and then a case in which the packaging substrate was warped or the crack prevention layer was deformed was evaluated as Fail, and a case in which the packaging substrate was not warped or the crack prevention layer was not deformed was evaluated as Pass.

The evaluation results for Examples and Comparative Example were listed in the following Table 1.

### Evaluation Example: Evaluation of various properties of crack prevention layer

The tensile strength of the crack prevention layer in the packaging substrate of Example 1 was measured using a universal testing machine (UTM) at room temperature.

The linear thermal expansion coefficient of the crack prevention layer was measured using dynamic mechanical analysis (DMA).

The dielectric constant of the crack prevention layer at a frequency of 100 Hz and the dielectric constant at a frequency of 100 kHz were measured using a dielectric constant meter.

The measured values for Example 1 were listed in the following Table 2.

**[Table 1]**

| | Thickness of crack prevention layer (µm) | Ratio of thickness of crack prevention layer to thickness of glass core | Maximum value of peel strength (gf) | Average value of peel strength (gf) | Thermal resistance evaluation |
|---|---|---|---|---|---|
| Example 1 | 8 | 0.011 | 751.8 | 691.5 | Pass |
| Example 2 | 7 | 0.010 | 871.6 | 683.4 | Pass |
| Example 3 | 10 | 0.014 | 795.2 | 687.4 | Pass |
| Example 4 | 11 | 0.016 | 837.9 | 776.9 | Pass |
| Comparative Example 1 | 8 | 0.011 | - | - | Fail |

**[Table 2]**

| | Tensile strength (MPa) | Linear thermal expansion coefficient (ppm/°C) | Dielectric constant at frequency of 100 Hz | Dielectric constant at frequency of 100 KHz |
|---|---|---|---|---|
| Example 1 | 6.7 | 340 | 2.72 | 2.68 |

In Table 1, an average value of the peel strength for each Example was shown to be 600 gf or more. This means that adhesion of the electrically conductive layer to the crack prevention layer is excellent in all Manufacturing Examples.

In the thermal resistance evaluation, Examples 1 to 4 were all evaluated as Pass, whereas Comparative Example 1 was evaluated as Fail.

Although preferable embodiments of the present disclosure have been described above in detail, the scope of the present invention is not limited thereto, and various modifications and improvements made by those skilled in the art using the basic concepts of the present invention also belong to the scope of the present invention.

## Claims

1. A packaging substrate comprising a glass core,
wherein the glass core comprises a through via passing through the glass core in a thickness direction of the glass core,
the glass core comprises a surface,
the packaging substrate comprises a crack prevention layer surrounding at least a portion of the surface of the glass core, and
a ratio of a thickness of the crack prevention layer to a thickness of the glass core is 0.0001 to 0.05.

2. The packaging substrate of claim 1, wherein a tensile strength of the crack prevention layer is 1 Mpa to 20 Mpa.

3. The packaging substrate of claim 1, wherein a linear thermal expansion coefficient of the crack prevention layer is 100 ppm/°C to 800 ppm/°C.

4. The packaging substrate of claim 1, wherein a dielectric constant of the crack prevention layer at a frequency of 100 Hz is 4 or less.

5. The packaging substrate of claim 1, further comprising a first electrically conductive layer disposed on the crack prevention layer,
wherein a peel strength of the first electrically conductive layer with respect to the crack prevention layer is 300 gf or more.

6. The packaging substrate of claim 5, further comprising an adhesion reinforcement layer disposed between the crack prevention layer and the first electrically conductive layer.

7. The packaging substrate of claim 5, wherein the crack prevention layer is roughened.

8. The packaging substrate of claim 1, wherein at least a portion of the crack prevention layer is disposed in contact with the surface of the glass core, and
a peel strength of the crack prevention layer with respect to the surface of the glass core is 400 gf or more.

9. The packaging substrate of claim 1, wherein the crack prevention layer comprises a silicone elastomer.

10. The packaging substrate of claim 1,
wherein the surface of the glass core comprises an upper surface and side surfaces connected to the upper surface and formed in the thickness direction of the glass core, and
the crack prevention layer surrounds the side surfaces of the glass core.

11. The packaging substrate of claim 1,
wherein the through via comprises an inner space and a via inner diameter surface surrounding the inner space,
the crack prevention layer is disposed between the inner space and the via inner diameter surface, and
a minimum value of a diameter of the inner space is 50 µm or more.

12. A semiconductor package, comprising:
the packaging substrate according to claim 1; and
a semiconductor element mounted on the packaging substrate.
